# FASCICULE DE BREVET EUROPEEN

(11) **EP 4 037 174 B1**
(45) Date de publication et mention de la délivrance du brevet: **26.11.2025**
(21) Numéro de dépôt: 22153325.0
(22) Date de dépôt: 25.01.2022
(51) Int. Cl.: H02M 3/158

(54) **SYNCHRONISATION D'UN DISPOSITIF ÉLECTRONIQUE**
SYNCHRONISIERUNG EINER ELEKTRONISCHEN VORRICHTUNG
SYNCHRONISATION OF AN ELECTRONIC DEVICE

(30) Priorité: 29.01.2021 FR 2100872
(43) Date de publication de la demande: 03.08.2022
(73) Titulaire: STMicroelectronics (Rousset) SAS, 13790 Rousset (FR)
(72) Inventeur: ORTET, Sebastien, 13790 Châteauneuf-le-Rouge (FR); BINET, Vincent, 13100 Aix-en-Provence (FR)
(74) Mandataire: Cabinet Beaumont

(56) Documents cités:
- US-A1- 2011 101 946
- US-A1- 2013 294 118
- US-B2- 10 560 013
- US-B2- 10 892 684
- US-B2- 9 036 377
- WANG PAI-YI ET AL: "A current-mode buck converter with bandwidth reconfigurable for enhanced efficiency and improved load transient response", 2014 IEEE ASIAN SOLID-STATE CIRCUITS CONFERENCE (A-SSCC), IEEE, 10 November 2014 (2014-11-10), pages 69 - 72, XP032719740, ISBN: 978-1-4799-4090-5, [retrieved on 20150113], DOI: 10.1109/ASSCC.2014.7008862

## Description

### Domaine technique

La présente description concerne de façon générale les circuits et dispositifs électroniques, et de façon plus particulière la synchronisation de dispositifs électroniques à un signal d'horloge. La présente description concerne en particulier un dispositif comprenant au moins une alimentation à découpage.

### Technique antérieure

Dans un convertisseur à découpage, une tension d'alimentation du convertisseur est découpée (ou hachée) en commutant des interrupteurs de manière à mettre en œuvre des phases d'accumulation d'énergie dans un ensemble comprenant un élément inductif et un élément capacitif et des phases de restitution, à une charge connectée en sortie du convertisseur, de l'énergie accumulée dans cet ensemble.

De manière à mettre en œuvre les différentes phases de fonctionnement du convertisseur, le convertisseur à découpage comprend par exemple un circuit de génération d'un signal d'horloge. Le signal d'horloge est par exemple un signal variant de façon périodique entre des niveaux haut et bas correspondant respectivement à des états haut et bas d'un signal binaire.

La publication US 10560013 B2 divulgue une alimentation à découpage et un circuit de génération d'un signal d'horloge pour un mode synchrone et pour un mode asynchrone de suppression d'impulsions.

### Résumé de l'invention

L'invention est exposée dans le jeu de revendications joint.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un dispositif électronique ;
la figure 2 est un ensemble de chronogrammes illustrant le fonctionnement d'un mode de réalisation d'un circuit de génération d'un signal d'horloge ;
la figure 3 représente schématiquement un exemple d'implémentation d'un circuit de génération d'un signal d'horloge dont le fonctionnement est décrit en figure 2 ;
la figure 4 est un ensemble de chronogrammes illustrant le fonctionnement du dispositif de la figure 1 comprenant le mode de réalisation de la figure 3 ;
la figure 5 est un ensemble de chronogrammes illustrant le fonctionnement d'un autre mode de réalisation d'un circuit de génération d'un signal d'horloge ;
la figure 6 représente schématiquement un mode de réalisation d'un circuit de génération d'un signal d'horloge dont le fonctionnement est décrit en figure 5 ; et
la figure 7 est un ensemble de chronogrammes illustrant le fonctionnement du dispositif de la figure 1 comprenant le mode de réalisation de la figure 6.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

L'invention est définie par les revendications indépendantes annexées. Divers modes de réalisation sont définis par les revendications dépendantes.

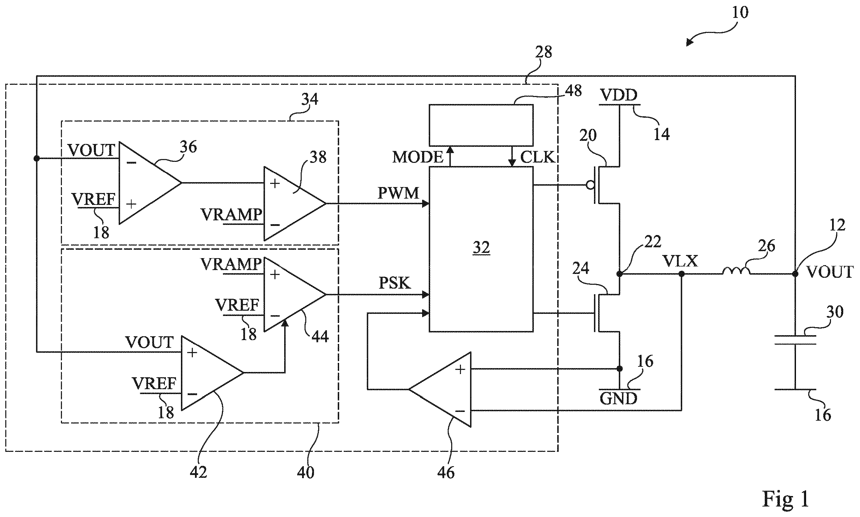

La figure 1 représente un mode de réalisation d'un dispositif électronique 10. Le dispositif 10 est un convertisseur de tension. Dans cet exemple, le convertisseur 10 est un convertisseur DC/DC, de type alimentation à découpage, qui convertit une tension continue (DC) d'alimentation en une tension continue (DC) de sortie.

Le convertisseur 10 est configuré pour fournir une tension continue de sortie VOUT. Le convertisseur comprend un nœud de sortie 12, sur lequel est disponible la tension VOUT.

Le convertisseur 10 est alimenté par une tension continue d'alimentation VDD. Le convertisseur 10 est alors connecté entre un premier rail conducteur, ou nœud, 14 mis à la tension VDD, et un deuxième rail conducteur, ou nœud, 16 mis à un potentiel de référence GND, par exemple la masse.

Le convertisseur 10 est configuré pour fournir la tension VOUT à une valeur sensiblement égale à une valeur de consigne. Pour cela, le convertisseur 10 reçoit, sur un nœud d'entrée 18, une tension continue de consigne VREF, par exemple référencée par rapport au potentiel GND, dont la valeur est représentative de la valeur de consigne de la tension VOUT, de préférence égale à la valeur de consigne de la tension VOUT. Dans cet exemple, les tensions VOUT, VDD et VREF sont positives.

Dans cet exemple, le convertisseur 10 est de type abaisseur ou « buck », c'est-à-dire que la valeur de consigne de la tension VOUT est inférieure à la valeur de la tension VDD. Autrement dit, la valeur de la tension VOUT est inférieure à celle de la tension VDD.

Le convertisseur 10 comprend un premier transistor MOS ("metal oxyde semiconductor" - métal oxyde semiconducteur) 20, de préférence un transistor PMOS (transistor MOS à canal P). Le transistor MOS 20 est connecté entre le rail 14 et un nœud interne 22 sur lequel est appliquée une tension VLX. Dit autrement, une première borne de conduction du transistor 20, par exemple sa source, est connectée au rail 14, une deuxième borne de conduction du transistor 20, par exemple son drain, étant connectée au nœud 22.

Le convertisseur 10 comprend en outre un deuxième transistor MOS 24, de préférence un transistor NMOS (transistor MOS à canal N). Le transistor 24 est connecté entre le nœud 22 et le rail 16. Autrement dit, une première borne de conduction du transistor 24, par exemple sa source, est connectée au rail 16, une deuxième borne de conduction du transistor 24, par exemple son drain, étant connectée au nœud 22.

Ainsi, les transistors 20 et 24 sont connectés en série entre les rails 14 et 16, et sont connectés l'un à l'autre au niveau du nœud interne 22.

Le convertisseur 10 comprend un élément inductif ou inductance 26. L'inductance 26 est connectée entre le nœud 22 et le nœud 12.

Le convertisseur 10 comprend une capacité de sortie 30 connectée entre le nœud 12 et le rail 16. A titre d'exemple, cette capacité est de l'ordre de 2,2 µF à 20 µF, voire plus. Cette capacité de sortie joue le rôle de filtre. Dit autrement, cette capacité de sortie du convertisseur permet de lisser le courant présent sur le nœud 12 et de stocker de l'énergie fournie au nœud 12 par le convertisseur.

En fonctionnement, une charge non représentée est connectée entre le nœud 12 et le rail 16 de manière à être alimentée par la tension VOUT.

Le convertisseur 10 comprend un circuit de commande 28. Le circuit 28 est configuré pour commander le fonctionnement du convertisseur 10, de manière à réguler la tension VOUT, par exemple pour que sa valeur soit égale à la valeur de consigne VREF.

Le convertisseur 10 comprend deux modes de fonctionnement, un mode de fonctionnement synchrone et un mode de fonctionnement asynchrone.

Un premier mode de fonctionnement est dit mode de conduction continue (« Continuous Conduction Mode » - CCM), par exemple de type PWM, c'est-à-dire à modulation d'amplitude d'impulsion ("Pulse Width Modulation") ou de type PFM, c'est-à-dire à modulation de fréquence d'impulsion ("Pulse Frequency Modulation"), dans lequel chaque cycle de fonctionnement du convertisseur comprend une phase d'accumulation d'énergie dans l'inductance 26 et le condensateur 30 suivie d'une phase de restitution d'énergie à la charge connectée au convertisseur. Pendant la phase d'accumulation d'énergie, le courant traversant l'élément inductif 26 augmente. Pendant la phase de restitution d'énergie, le courant traversant l'élément inductif 26 diminue. Ce mode de fonctionnement est un mode synchrone, synchronisé par un signal binaire d'horloge CLK, par exemple à une fréquence de 2,4 MHz. Un tel mode de fonctionnement est par exemple considéré le mode de fonctionnement normal du convertisseur.

Un deuxième mode de fonctionnement est dit mode de suppression d'impulsion (« Pulse Skipping » - PSK). Dans ce mode de fonctionnement, le transistor 24 est par exemple maintenu bloqué et le transistor 20 est rendu passant lorsque la tension de sortie VOUT est inférieure à une tension de référence, par exemple la tension de consigne VREF. Ainsi, une phase d'accumulation d'énergie est mise en œuvre lorsque la tension de sortie est inférieure à la tension de consigne VREF. Un tel mode de fonctionnement est par exemple mis en œuvre lorsque le courant tiré par la charge est faible. Ce mode de fonctionnement est un mode de fonctionnement asynchrone.

Le circuit de commande 28 comprend un circuit 32, par exemple une machine d'état, générant les signaux de commande des transistors 20 et 24. Le circuit 32 comprend ainsi une sortie reliée, de préférence connectée, à la borne de commande du transistor 20, sur laquelle est fournie le signal de commande du transistor 20. Le circuit 32 comprend de plus une sortie reliée, de préférence connectée, à la borne de commande du transistor 24, sur laquelle est fournie le signal de commande du transistor 24.

Le circuit 32 comprend, en outre, une entrée reliée à un circuit 34 de commande du premier mode de fonctionnement, sur laquelle le circuit 32 reçoit un signal PWM déterminant, selon la différence entre la tension de sortie VOUT et la tension de consigne VREF, l'amplitude ou la fréquence des phases d'accumulation ou de restitution d'énergie dans le premier mode de fonctionnement. Ainsi, le signal PWM est utilisé par le circuit 32 dans le premier mode de fonctionnement et est par exemple inutilisé durant le deuxième mode de fonctionnement.

Le circuit 34 comprend par exemple un comparateur 36 configuré pour comparer la tension de sortie VOUT à la tension de consigne VREF. Le comparateur 36 comprend une entrée, de préférence une entrée non inverseuse, reliée, de préférence connectée, au nœud 18 d'application de la tension VREF. Le comparateur 36 comprend, en outre, une entrée, de préférence une entrée inverseuse, reliée, de préférence connectée, au nœud 12. Le comparateur 36 comprend une sortie sur laquelle est fournie un signal représentatif de la différence entre la tension VOUT et la tension de consigne VREF.

Le circuit 34 comprend un autre comparateur 38. Le comparateur 38 comprend une entrée, de préférence une entrée non inverseuse, reliée, de préférence connectée, à la sortie du comparateur 36. Le comparateur 38 comprend en outre une autre entrée, de préférence une entrée inverseuse, reliée, de préférence connectée, à un nœud d'application d'une rampe de tension VRAMP. Le comparateur 38 comprend une sortie sur laquelle il fournit le signal PWM. La sortie du comparateur est reliée, de préférence connectée, à une des entrées du circuit 32.

Le circuit 32 comprend, en outre, une entrée reliée à un circuit 40 de commande du deuxième mode de fonctionnement, sur laquelle le circuit 32 reçoit un signal PSK déterminant, selon la différence entre la tension de sortie VOUT et la tension de consigne VREF, les instants, dans le deuxième mode de fonctionnement, d'accumulation d'énergie. Autrement dit, pour une première valeur du signal PSK, obtenue lorsque la tension de sortie est inférieure à la tension de consigne VREF, le transistor 20 est passant de manière à permettre la charge du condensateur 30. Pour une deuxième valeur du signal PSK, le transistor 20 est bloqué, le transistor 24 étant de préférence maintenu bloqué durant le deuxième mode de fonctionnement. Ainsi, le signal PSK est utilisé par le circuit 32 dans le deuxième mode de fonctionnement et est par exemple inutilisé durant le premier mode de fonctionnement.

Le circuit 40 comprend par exemple un comparateur 42 configuré pour comparer la tension de sortie VOUT à la tension de consigne VREF. Le comparateur 40 comprend une entrée, de préférence une entrée inverseuse, reliée, de préférence connectée, au nœud 18 d'application de la tension VREF. Le comparateur 40 comprend, en outre, une entrée, de préférence une entrée non inverseuse, reliée, de préférence connectée, au nœud 12. Le comparateur 40 comprend une sortie sur laquelle est fournie un signal représentatif de la différence entre la tension VOUT et la tension de consigne VREF.

Le circuit 34 comprend un autre comparateur 44. Le comparateur 44 comprend une entrée, de préférence une entrée non inverseuse, reliée, de préférence connectée, à un nœud d'application d'une rampe de tension, par exemple la rampe VRAMP. Le comparateur 44 comprend en outre une autre entrée, de préférence une entrée inverseuse, reliée, de préférence connectée, au nœud 18 d'application de la tension de consigne VREF. Le comparateur 44 comprend une entrée de commande reliée, de préférence connectée, à la sortie du comparateur 42. Le comparateur 44 comprend une sortie sur laquelle le signal PSK est fourni pour une valeur du signal de sortie du comparateur 42. La sortie du comparateur est reliée, de préférence connectée, à une des entrées du circuit 32.

Ainsi, lorsque le convertisseur 10 est dans le premier mode de fonctionnement, le circuit 32 prend en compte le signal PWM pour déterminer les signaux de commande des transistors 20 et 24 et ne prend pas en compte le signal PSK. Lorsque le convertisseur 10 est dans le deuxième mode de fonctionnement, le circuit 32 prend en compte le signal PSK pour déterminer les signaux de commande des transistors 20 et 24 et ne prend pas en compte le signal PWM.

Le circuit 28 comprend en outre un comparateur 46. Le comparateur 46 comprend une première entrée, de préférence une entrée non inverseuse, reliée, de préférence connectée, au nœud 16 d'application de la tension GND, et une deuxième entrée, de préférence une entrée inverseuse, reliée, de préférence connectée, au nœud 22. Le comparateur 46 comprend une sortie reliée, de préférence connectée, au circuit 32, fournissant un signal représentatif de la différence entre la tension VLX sur le nœud 22 et la tension sur le nœud 16. Autrement dit, le comparateur fournit au circuit 32 un signal représentatif du signe de la tension VLX. Si le convertisseur fonctionne dans le premier mode de fonctionnement et que le comparateur détermine que la tension VLX est inférieure à la tension GND, le circuit 32 fait entrer le convertisseur dans le deuxième mode de fonctionnement.

Le circuit 28 comprend en outre un circuit 48 de génération du signal d'horloge CLK. Le circuit 28 comprend ainsi une sortie reliée, de préférence connectée, au circuit 32 sur laquelle est fourni le signal CLK.

Le circuit 48 comprend une entrée reliée, de préférence connectée, au circuit 32 sur laquelle est fourni un signal MODE représentatif du mode de fonctionnement du convertisseur. Par exemple, le signal MODE prend une première valeur lorsque le convertisseur 10 fonctionne dans le premier mode de fonctionnement et une deuxième valeur lorsque le convertisseur 10 fonctionne dans le deuxième mode de fonctionnement. Le signal MODE prend donc la deuxième valeur lorsque le convertisseur passe du premier au deuxième mode de fonctionnement, autrement dit lorsque le comparateur 46 détermine que la tension VLX est inférieure à la tension GND. Le signal MODE prend par exemple la première valeur lorsque le courant tiré par la charge augmente fortement.

Lorsque le convertisseur passe du deuxième mode de fonctionnement au premier mode de fonctionnement, le convertisseur passe d'un mode asynchrone à un mode synchrone. Le circuit 48, et en particulier le circuit 32, doit être resynchronisé. Le circuit 32 est synchronisé sur les fronts montants ou descendants, de préférence montants, du signal d'horloge CLK. Lors du passage au premier mode de fonctionnement, il peut exister une durée, entre le changement de valeur du signal MODE et le prochain front montant du signal d'horloge durant laquelle une grande quantité d'énergie est tirée par la charge et le transistor 20 reliant le nœud d'application de la tension d'alimentation et le nœud 22 est bloqué. Le condensateur 30 se décharge donc rapidement durant cette période, ce qui peut entrainer une chute non négligeable de la tension alimentant la charge.

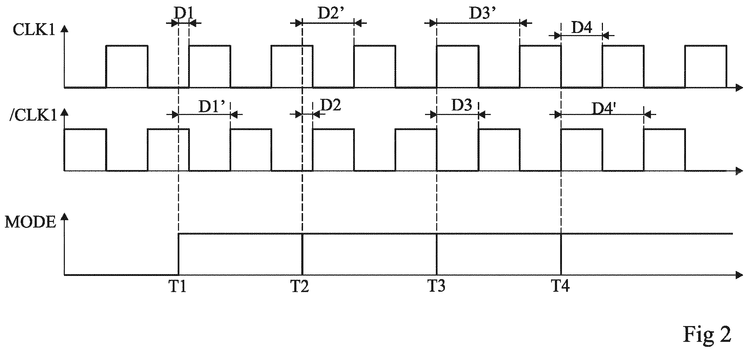

Les figures 2, 3 et 4 illustrent un mode de réalisation d'un circuit de génération d'un signal d'horloge dépendant du signal MODE, et dépendant ainsi du mode de fonctionnement du convertisseur.

La figure 2 est un ensemble de chronogrammes illustrant le fonctionnement d'un mode de réalisation d'un circuit de génération d'un signal d'horloge 48. Le circuit 48 est configuré, dans ce mode de réalisation, pour fournir, lors du passage de deuxième mode de fonctionnement asynchrone au premier mode de fonctionnement synchrone, un signal parmi un signal d'horloge CLK1 binaire et un signal d'horloge complémentaire au premier signal d'horloge /CLK1, ayant le front montant le plus proche.

La figure 2 comprend un chronogramme représentant, en fonction du temps, le signal d'horloge CLK1, généré par exemple par un oscillateur compris dans le circuit 48, un chronogramme représentant, en fonction du temps, le signal d'horloge complémentaire /CLK1, et un chronogramme représentant, en fonction du temps, le signal MODE, et illustrant ainsi le mode de fonctionnement du convertisseur.

La figure 2 représente quatre cas distincts et indépendants de passage du deuxième mode de fonctionnement au premier mode de fonctionnement.

Dans l'exemple de la figure 2, une première valeur du signal MODE, correspondant au premier mode de fonctionnement, c'est-à-dire le mode de fonctionnement synchrone, est une valeur haute, et une deuxième valeur du signal MODE, correspondant au deuxième mode de fonctionnement, c'est-à-dire le mode de fonctionnement asynchrone, est une valeur basse.

Dans un premier cas, l'instant de passage du deuxième mode de fonctionnement au premier mode de fonctionnement est un instant T1. A l'instant T1, le signal MODE passe de la valeur basse à la valeur haute. De plus, à l'instant T1, le signal CLK1 a une valeur basse et son signal complémentaire /CLK1 a une valeur haute. La durée entre l'instant T1 et le front montant le plus proche du signal CLK1 est une durée D1 et la durée entre l'instant T1 et le front montant le plus proche du signal complémentaire /CLK1 du signal CLK1 est une durée D1'. La durée D1 est inférieure à la durée D1'. Ainsi, le signal d'horloge CLK fourni par le circuit 48 au circuit 32, et avec lequel est synchronisé le convertisseur, est le signal CLK1.

Dans un deuxième cas, l'instant de passage du deuxième mode de fonctionnement au premier mode de fonctionnement est un instant T2. A l'instant T2, le signal MODE passe de la valeur basse à la valeur haute. De plus, à l'instant T2, le signal CLK1 a une valeur haute et son signal complémentaire /CLK1 a une valeur basse. La durée entre l'instant T2 et le front montant le plus proche du signal CLK1 est une durée D2' et la durée entre l'instant T2 et le front montant le plus proche du signal complémentaire /CLK1 du signal CLK1 est une durée D2. La durée D2 est inférieure à la durée D2'. Ainsi, le signal d'horloge CLK fourni par le circuit 48 au circuit 32, et avec lequel est synchronisé le convertisseur, est le signal complémentaire du signal CLK1.

Dans un troisième cas, l'instant de passage du deuxième mode de fonctionnement au premier mode de fonctionnement est un instant T3. A l'instant T3, le signal MODE passe de la valeur basse à la valeur haute. De plus, l'instant T3 correspond sensiblement au front montant du signal CLK1 et au front descendant du signal complémentaire /CLK1. La durée entre l'instant T3 et le front montant suivant le plus proche du signal CLK1 est une durée D3' sensiblement égale à une période du signal d'horloge CLK1 et la durée entre l'instant T3 et le front montant le plus proche du signal complémentaire /CLK1 du signal CLK1 est une durée D3 correspondant à la moitié d'une période du signal d'horloge CLK1. La durée D3 est inférieure à la durée D3'. Ainsi, le signal d'horloge CLK fourni par le circuit 48 au circuit 32 et avec lequel est synchronisé le convertisseur est le signal complémentaire /CLK1 du signal CLK1.

Similairement, dans un quatrième cas, l'instant de passage du deuxième mode de fonctionnement au premier mode de fonctionnement est un instant T4. A l'instant T4, le signal MODE passe de la valeur basse à la valeur haute. De plus, l'instant T4 correspond sensiblement au front descendant du signal CLK1 et au front montant du signal complémentaire /CLK1. La durée entre l'instant T4 et le front montant suivant le plus proche du signal CLK1 est une durée D4 sensiblement égale à une moitié de la période du signal d'horloge CLK1 et la durée entre l'instant T4 et le front montant le plus proche du signal complémentaire /CLK1 du signal CLK1 est une durée D4' correspondant à une période du signal d'horloge CLK1. La durée D4 est inférieure à la durée D4'. Ainsi, le signal d'horloge CLK fourni par le circuit 48 au circuit 32 et avec lequel est synchronisé le convertisseur est le signal CLK1.

Lors du passage de deuxième mode de fonctionnement asynchrone au premier mode de fonctionnement synchrone, si le signal CLK1 a une valeur basse, le front montant le plus proche est un front montant du signal CLK1 et si le signal CLK1 a une valeur haute, le front montant le plus proche est un front montant du signal /CLK1.

Dans les pires cas, c'est-à-dire les troisième et quatrième cas, la durée entre le front montant du signal MODE, c'est-à-dire le passage entre le deuxième mode de fonctionnement et le premier mode de fonctionnement, et le front montant suivant du signal d'horloge CLK, autrement dit la durée durant laquelle le condensateur se décharge, est égal à une demi période du signal d'horloge.

On aurait pu choisir de fournir directement le signal CLK1 au circuit 32. Cependant, dans le pire cas, la durée entre le front montant du signal MODE et le front montant suivant du signal d'horloge CLK pourrait alors être sensiblement égale à la période entière du signal CLK1. Ce serait par exemple le cas pour l'instant T3.

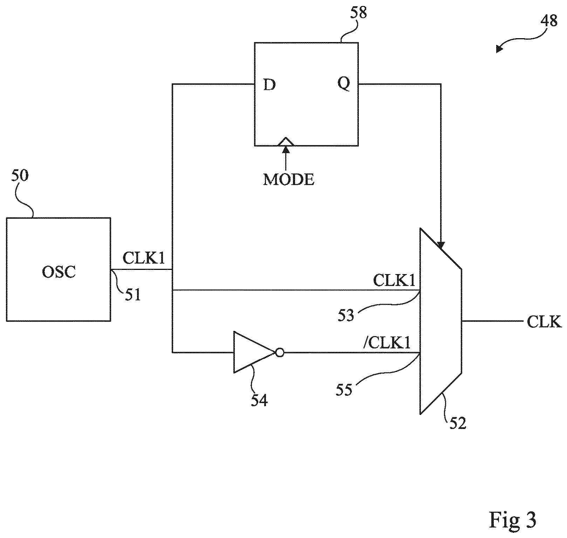

La figure 3 représente schématiquement un exemple d'implémentation d'un circuit de génération d'un signal d'horloge 48 dont le fonctionnement est décrit en figure 2.

Le circuit 48 comprend un circuit 50 (OSC), par exemple un circuit oscillateur, générant, sur une sortie 51, le signal d'horloge CLK1. Le signal CLK1 est périodique, de période constante. Le signal CLK1 n'est de préférence pas modifié durant les premier et deuxième modes de fonctionnement du convertisseur 10 et, en particulier, n'est de préférence pas modifié lors du passage du premier mode de fonctionnement au deuxième mode de fonctionnement ou de deuxième mode de fonctionnement au premier mode de fonctionnement.

Le circuit 48 comprend un circuit de sélection, ou multiplexeur, 52. Le multiplexeur 52 comprend une entrée 53 recevant le signal CLK1. L'entrée 53 est ainsi reliée, de préférence connectée, à la sortie 51 du circuit 50 sur laquelle est fourni le signal CLK1. Le multiplexeur 52 comprend une entrée 55 recevant le signal complémentaire /CLK1 du signal CLK1. L'entrée 55 est reliée à la sortie 51 par un circuit inverseur 54 générant en sortie le signal complémentaire du signal d'entrée. Le circuit 54 comprend une entrée reliée, de préférence connectée, à l'entrée 51 du multiplexeur 52 et une sortie reliée, de préférence connectée, à l'entrée 55 du multiplexeur 52.

Le circuit 48 comprend en outre une bascule 58, de préférence une bascule D. La bascule 58 comprend une entrée D de données reliée, de préférence connectée, au nœud 51. La bascule comprend en outre une entrée de signal d'horloge reliée, de préférence connectée, à un nœud d'application du signal MODE. La bascule 58 comprend une sortie Q reliée, de préférence connectée, à une borne de commande du multiplexeur 52.

Ainsi, l'entrée D reçoit de manière continue de signal d'horloge CLK1. Lors du passage du deuxième mode de fonctionnement au premier mode de fonctionnement, c'est à dire lors d'un front montant du signal MODE, la sortie Q prend la valeur du signal CLK1 à cet instant.

Si le signal CLK1 a une valeur basse, comme c'est le cas dans le premier cas de la figure 2, la valeur de la sortie Q est une valeur basse, par exemple la valeur binaire '0'. Le multiplexeur est configuré pour fournir en sortie le signal CLK1 reçu sur l'entrée 53, lorsque le signal de commande reçu sur l'entrée de commande à cette valeur basse.

Similairement, si le signal CLK1 a une valeur haute, comme c'est le cas dans le deuxième cas de la figure 2, la valeur de la sortie Q est une valeur haute, par exemple la valeur binaire '1'. Le multiplexeur est configuré pour fournir en sortie le signal, reçu sur l'entrée 55, complémentaire du signal CLK1, lorsque le signal de commande reçu sur l'entrée de commande à cette valeur haute.

Ainsi, le multiplexeur est configuré pour fournir en sortie le signal CLK1 si le signal CLK1 a une valeur basse lors du front montant du signal MODE, et pour fournir en sortie le signal complémentaire /CLK1 du signal CLK1 si le signal CLK1 a une valeur haute lors du front montant du signal MODE.

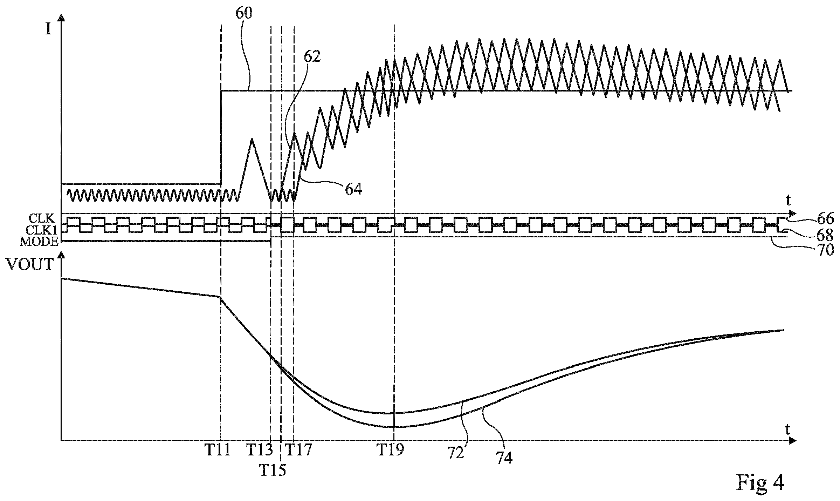

La figure 4 est un ensemble de chronogrammes illustrant le fonctionnement du dispositif de la figure 1 comprenant le mode de réalisation de la figure 3. En particulier, la figure 4 comprend un chronogramme illustrant des courants (I) :
- le courant tiré par la charge, par une courbe 60 ;
- le courant traversant l'inductance 26, dans le mode de réalisation des figures 1 à 3, par une courbe 62 ; et
- le courant traversant l'inductance 26, dans un convertisseur similaire au convertisseur 10 de la figure 1, le signal CLK étant égal au signal CLK1 quel que soit le mode de fonctionnement, par une courbe 64.

La figure 4 comprend un chronogramme illustrant des signaux binaires :
- le signal CLK, par une courbe 66 ;
- le signal CLK1, par une courbe 68 ; et
- le signal MODE, par une courbe 70.

La figure 4 comprend un chronogramme illustrant des tensions (VOUT) :
- la tension VOUT dans le mode de réalisation des figures 1 à 3, par une courbe 72 ; et
- la tension VOUT dans un convertisseur similaire au convertisseur 10 de la figure 1, le signal CLK étant égal au signal CLK1 quel que soit le mode de fonctionnement, par une courbe 74.

A un instant T11, la charge commence à tirer un courant plus important qu'avant l'instant T11. Autrement dit, à l'instant T11, le courant tiré par la charge (courbe 60) passe d'une valeur basse à une valeur haute. La tension de sortie VOUT commence à décroitre de manière plus importante qu'avant l'instant T11. A l'instant T11, le convertisseur est encore dans le mode de fonctionnement dans lequel le convertisseur était avant l'instant T11, c'est-à-dire le mode de fonctionnement asynchrone (PSK). Le signal MODE a, à l'instant T11 et avant l'instant T11, une valeur basse.

A un instant T13 postérieur à l'instant T11, le signal MODE prend une valeur haute signifiant que le convertisseur va passer dans le mode de fonctionnement synchrone (PWM). Ce changement est causé par le passage de la tension VOUT sous la valeur de la tension VREF en fin d'un cycle du mode PSK.

Avant l'instant T13, le signal CLK était égal au signal CLK1. A l'instant T13, le signal CLK1 a une valeur haute, donc le front le plus proche est un front descendant du signal CLK1, c'est-à-dire un front montant du signal complémentaire /CLK1 du signal CLK1. Le signal CLK devient ainsi, comme cela a été décrit précédemment, égal au signal complémentaire /CLK1 du signal CLK1.

Le premier front montant du signal CLK après l'instant T13 survient à un instant T15. A partir de l'instant T15, le courant moyen traversant l'inductance 26 augmente, de manière à charger le condensateur 30 et alimenter la charge. La tension VOUT, représentée par la courbe 72, diminue de manière moins importante puis commence à augmenter lorsque le courant, représenté par la courbe 62, atteint une valeur suffisamment importante, le condensateur étant chargé.

A un instant T17, le premier front montant du signal CLK1 après l'instant T13 survient. Dans un cas où le signal CLK reste égal au signal CLK1, l'instant T17 est l'instant auquel le courant moyen dans la charge commence à augmenter grâce aux transistors 20 et 24 qui sont alors bloqué et passant de manière alternée (mode PWM).

Le comportement du convertisseur du mode de réalisation des figures 2 et 3 à partir de l'instant T15 est similaire au comportement du convertisseur dans lequel le signal CLK est le signal CLK1, à partir de l'instant T17. Cependant, l'instant T17 survient une demi période du signal CLK1 après l'instant T15. Ce délai a pour conséquence que la chute de la tension VOUT survenant lors du passage du mode de fonctionnement asynchrone au mode de fonctionnement synchrone est inférieur dans le cas du convertisseur du mode de réalisation des figures 2 et 3 que dans le cas du convertisseur où le signal CLK est le signal CLK1. En effet, à un instant T19, postérieur aux instants T15 et T17, la différence entre les courbes 72 et 74 représentant la tension VOUT dans ces deux cas, est, dans cet exemple, de l'ordre de 5 mV, ce qui correspond approximativement à 10 % de la chute totale de tension après l'instant T11.

Ainsi, un avantage du mode de réalisation des figures 2 à 4 est que la durée maximale possible de décharge du condensateur est une demi période du signal CLK1, c'est-à-dire deux fois moins que dans le cas où le signal CLK1 est fourni directement au circuit 32. Ainsi, la chute de la tension VOUT lors du passage du deuxième mode de fonctionnement au premier mode de fonctionnement est inférieure à la chute dans le cas où le signal CLK1 est fourni directement au circuit 32.

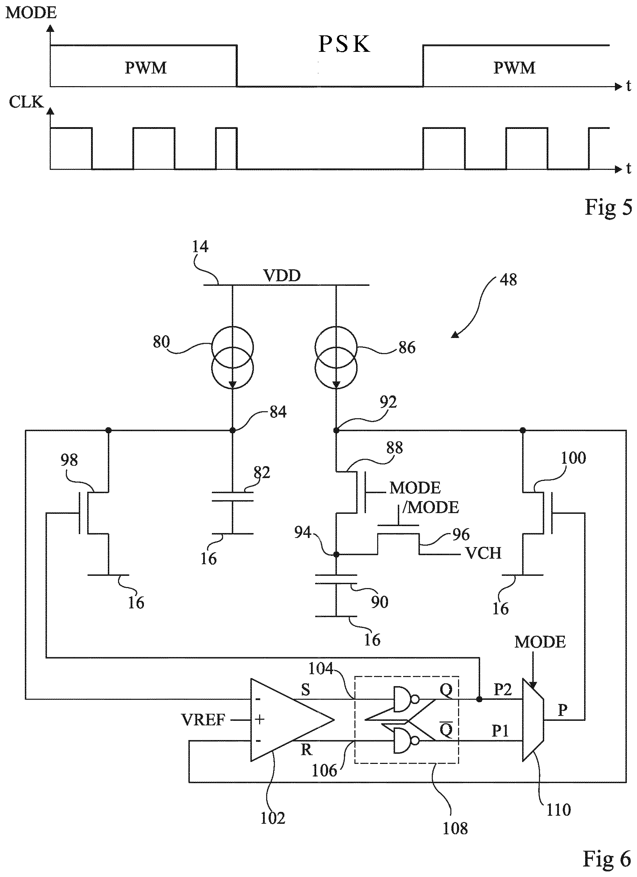

Les figures 5, 6 et 7 illustrent un autre mode de réalisation d'un circuit de génération d'un signal d'horloge dépendant du signal MODE, et dépendant ainsi du mode de fonctionnement du convertisseur.

La figure 5 est un ensemble de chronogrammes illustrant le fonctionnement d'un autre mode de réalisation d'un circuit de génération d'horloge 48.

La figure 5 comprend un chronogramme illustrant, en fonction du temps (t), le signal MODE. A figure 5 comprend en outre un chronogramme illustrant, en fonction du temps (t), le signal d'horloge CLK fourni au circuit 32 par le circuit 48.

La figure 5 représente trois phases de fonctionnement du convertisseur de la figure 1. Plus précisément, la figure 5 représente deux phases synchrones (PWM) séparées par une phase asynchrone (PSK).

Durant la première phase synchrone, le signal CLK alterne périodiquement entre une valeur haute et une valeur basse. Lors du passage entre la première phase synchrone et la phase asynchrone, c'est-à-dire lorsque le signal MODE passe d'une valeur haute à une valeur basse, le signal CLK prend sa valeur basse, de préférence une valeur sensiblement nulle.

Le passage entre la phase asynchrone et la deuxième phase synchrone, c'est-à-dire le moment lors duquel le signal MODE passe d'une valeur basse à une valeur haute, correspond à un front montant du signal CLK.

Autrement dit, le signal CLK est maintenu à une valeur constante, de préférence la valeur basse, lors du mode de fonctionnement asynchrone et reprend sa périodicité, de préférence par un front montant, lors du passage au mode synchrone.

La figure 6 représente schématiquement un mode de réalisation d'un circuit de génération d'horloge 48 dont le fonctionnement est décrit en figure 5.

Le circuit 48 comprend une source de courant 80 reliée, de préférence connectée, en série avec un condensateur 82 entre un nœud d'application d'une tension d'alimentation, par exemple le nœud 14 d'application de la tension VDD, et un nœud d'application d'une tension de référence, par exemple le nœud 16 d'application de la tension GND. De préférence, la source 80 comprend une borne reliée, de préférence connectée, au nœud 14 et une autre borne reliée, de préférence connectée, à un nœud 84. De préférence, le condensateur 82 comprend une borne reliée, de préférence connectée, au nœud 84 et une autre borne reliée, de préférence connectée, au nœud 16.

Le circuit 48 comprend, en outre, une autre source de courant 86 reliée, de préférence connectée, en série avec un interrupteur 88, par exemple un transistor, et un condensateur 90 entre un nœud d'application d'une tension d'alimentation, par exemple le nœud 14 d'application de la tension VDD, et un nœud d'application d'une tension de référence, par exemple le nœud 16 d'application de la tension GND. De préférence, la source 86 comprend une borne reliée, de préférence connectée, au nœud 14 et une autre borne reliée, de préférence connectée, à un nœud 92. De préférence, l'interrupteur comprend une borne, par exemple une borne de conduction, reliée, de préférence connectée, au nœud 92 et une autre borne, par exemple une borne de conduction, reliée, de préférence connectée, à un nœud 94. De préférence, le condensateur 90 comprend une borne reliée, de préférence connectée, au nœud 94 et une autre borne reliée, de préférence connectée, au nœud 16.

L'ensemble comprenant la source 80 et le condensateur 82 est ainsi relié en parallèle de l'ensemble comprenant la source 86, l'interrupteur 88 et le condensateur 90.

En outre, le circuit 48 comprend un interrupteur 96, par exemple un transistor, reliée entre le nœud 94 et un nœud d'application d'une tension VCH. Plus précisément, une borne de l'interrupteur 96, par exemple une borne de conduction, est reliée, de préférence connectée, au nœud 94 et une autre borne, de préférence une borne de conduction, est reliée, de préférence connectée, au nœud d'application de la tension VCH. La tension VCH est supérieure ou égale à la tension de consigne VREF, par exemple supérieure ou égale à 0,8 V.

Les transistors 88 et 96 sont commandés par des signaux complémentaires. Ainsi, lorsque l'un des transistors 88 et 96 est bloqué, l'autre est passant. De préférence, l'un des transistors 88 et 96 est commandé par le signal MODE, et l'autre est commandé par le signal /MODE, complémentaire du signal MODE. Ainsi, une borne de commande de l'interrupteur 88 est de préférence reliée, de préférence connectée, à un nœud d'application du signal MODE et une borne de commande de l'interrupteur 96 est de préférence reliée, de préférence connectée, à un nœud d'application du signal /MODE.

Le circuit 48 comprend en outre un interrupteur 98, par exemple un transistor, relié entre le nœud 84 et le nœud 14. Plus précisément, l'interrupteur 98 comprend une borne, par exemple une borne de conduction, reliée, de préférence connectée, au nœud 84 et une autre borne, par exemple une autre borne de conduction, reliée, de préférence connectée, au nœud 16. L'interrupteur 98 est ainsi relié en parallèle avec le condensateur 82. L'interrupteur 98 et la source 80 sont ainsi reliés en série entre les nœuds 14 et 16.

Similairement, le circuit 48 comprend un interrupteur 100, par exemple un transistor, relié entre le nœud 92 et le nœud 14. Plus précisément, l'interrupteur 100 comprend une borne, par exemple une borne de conduction, reliée, de préférence connectée, au nœud 92 et une autre borne, par exemple une autre borne de conduction, reliée, de préférence connectée, au nœud 16. L'interrupteur 100 est ainsi relié en parallèle avec l'ensemble comprenant le condensateur 90 et l'interrupteur 88. L'interrupteur 100 et la source 86 sont ainsi reliés en série entre les nœuds 14 et 16.

Durant le mode de fonctionnement asynchrone, les signaux de commande des transistors 98 et 100 sont des signaux complémentaires l'un à l'autre. Autrement dit, lorsque le transistor 98 est passant, le transistor 100 est bloqué et inversement.

Le circuit 48 comprend un circuit comparateur 102 configuré pour comparer la tension sur le nœud 84 à une tension de référence, de préférence la tension de consigne VREF, et pour comparer la tension sur le nœud 92 à une tension de référence, de préférence la même tension comparée à la tension sur le nœud 84, de préférence la tension VREF.

Le circuit 102 comprend une entrée, de préférence une entrée inverseuse d'un comparateur, reliée, de préférence connectée, au nœud 84. Le circuit 102 comprend une entrée, de préférence une entrée inverseuse d'un comparateur, reliée, de préférence connectée, au nœud 92. Le circuit 102 comprend une entrée, de préférence une entrée inverseuse d'un comparateur, reliée, de préférence connectée, à un nœud d'application de la tension de référence. Le circuit 102 comprend une sortie reliée, de préférence connectée, à un nœud 104 sur lequel est fourni un signal S représentant la comparaison entre la tension sur le nœud 84 et la tension de référence. Le circuit 102 comprend une sortie reliée, de préférence connectée, à un nœud 106 sur lequel est fourni un signal R représentant la comparaison entre la tension sur le nœud 92 et la tension de référence.

Le circuit 102 est relié en sortie à une bascule RS 108, par exemple formée par des portes logiques NON ET. Plus précisément, la bascule 108 comprend une première entrée, de préférence une entrée dite "Set", reliée, de préférence connectée, au nœud 104 et une deuxième entrée, de préférence une entrée "Reset", reliée au nœud 106. La bascule comprend une première sortie dite "Q" et une deuxième sortie "Q". La première sortie fourni le signal de commande binaire P2 de l'interrupteur 98. Ainsi, la première sortie de la bascule 108 est reliée, de préférence connectée, à la borne de commande du transistor 98. La deuxième sortie fourni un signal P1 complémentaire au signal P2.

Le circuit 48 comprend en outre un circuit 110 de sélection. Le circuit 110 reçoit en entrée les signaux P1 et P2 et fournit en sortie un signal P de commande de l'interrupteur 100. Plus précisément, une entrée du circuit 110 est reliée, de préférence connectée, à la sortie "Q" de la bascule 108 et une autre entrée du circuit 110 est reliée, de préférence connectée, à la sortie "Q̅" de la bascule 108. La sortie du circuit 110 est reliée, de préférence connectée, à la borne de commande de l'interrupteur 100.

Le circuit 110 comprend, en outre, une entrée de commande recevant le signal MODE. Le circuit 110 est configuré pour fournir en sortie le signal P1 si le signal MODE a une première valeur, de préférence la valeur haute, et pour fournir en sortie le signal P2 si le signal MODE a la valeur basse.

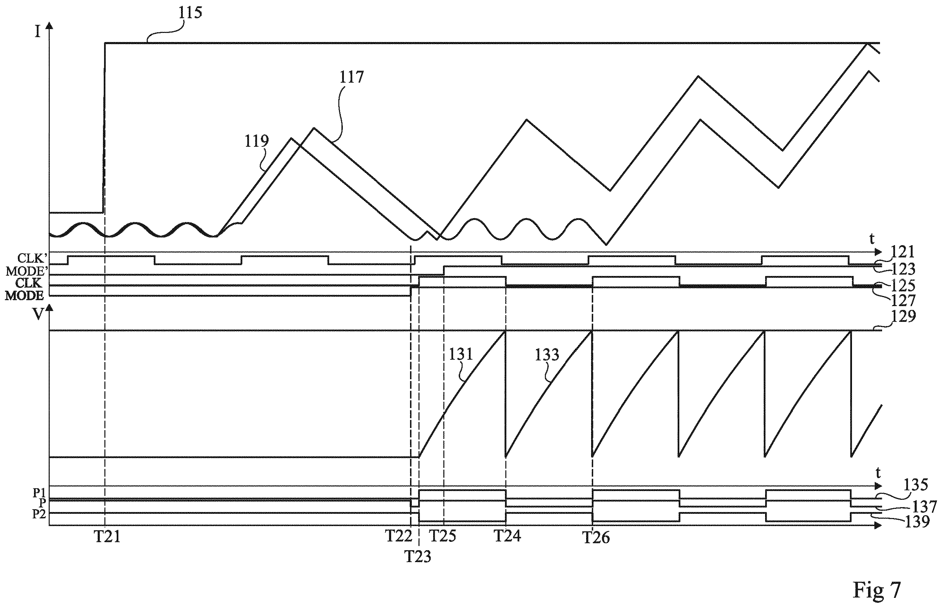

La figure 7 est un ensemble de chronogrammes illustrant le fonctionnement du dispositif de la figure 1 comprenant le mode de réalisation de la figure 6.

La figure 7 comprend un chronogramme illustrant des courants (I) :
- le courant tiré par la charge, représenté par une courbe 115 ;
- le courant traversant l'inductance 26 lors du fonctionnement du mode de réalisation de la figure 6, représenté par une courbe 117 ; et
- le courant traversant l'inductance 26 dans un convertisseur similaire au convertisseur de la figure 1 dans lequel le signal d'horloge périodique, non modifié, est fourni au circuit 32 représenté par une courbe 119.

La figure 7 comprend un chronogramme illustrant des signaux binaires :
- un signal d'horloge CLK' fournit au circuit 32 dans le convertisseur correspondant à la courbe 119, représenté par une courbe 121 ;
- un signal MODE' du convertisseur correspondant à la courbe 119, représenté par une courbe 123 ;
- un signal d'horloge CLK fournit au circuit 32 dans le mode de réalisation de la figure 6, représenté par une courbe 125 ; et
- le signal MODE du mode de réalisation de la figure 6, représenté par une courbe 127.

La figure 7 comprend un chronogramme illustrant des tensions (V) :
- la tension VREF, représentée par une courbe 129 ;
- la tension sur le nœud 84, représentée par une courbe 131 ; et
- la tension sur le nœud 92, représentée par une courbe 133.

La figure 7 comprend un chronogramme illustrant des signaux binaires :
- le signal P1, représenté par une courbe 135 ;
- le signal P, représenté par une courbe 137 ; et
- le signal P2, représenté par une courbe 139.

A un instant T21, la charge commence à tirer un courant plus important qu'avant l'instant T21. Autrement dit, à l'instant T21, le courant tiré par la charge (courbe 115) passe d'une valeur basse à une valeur haute. L'instant T21 survient alors que le dispositif fonctionnement dans le mode de fonctionnement asynchrone.

Dans le mode de fonctionnement asynchrone, correspondant à une valeur basse du signal MODE, le signal CLK est maintenu à une valeur constante, ici une valeur basse.

Le signal P2, commandant le transistor 98, a une valeur haute, maintenant le transistor 98 passant. Ainsi, le nœud 84 est relié au nœud 16 par un transistor passant et la tension sur le nœud 84 (courbe 131) est sensiblement égale à la tension sur le nœud 16, c'est-à-dire à 0 V, le condensateur 82 se déchargeant sur le nœud 16.

De plus, le transistor 88 est bloqué et le transistor 96 est passant, ces transistors étant respectivement commandés par les signaux MODE et /MODE. Les transistors 88 et 96 sont ainsi dans des états opposés. Ainsi, le nœud 94 est relié au nœud d'application de la tension VCH par un transistor passant. Autrement dit, la tension aux bornes du condensateur 90 est la tension VCH.

Le signal MODE ayant une valeur basse, le signal P prend la valeur du signal P2, c'est-à-dire la valeur haute. Le transistor 100 est ainsi passant et le condensateur se décharge sur le nœud 16. La tension sur le nœud 92 (courbe 133) est sensiblement égale à la tension sur le nœud 16, c'est-à-dire à 0 V.

Ainsi, dans le mode asynchrone les signaux de commande des transistors 98 et 100 sont tels que les transistors soient passants, de préférence les signaux de commande des transistors 98 et 100 sont sensiblement égaux.

A un instant T22, la tension VLX (non représentée en figure 7) sur le nœud 22 devient inférieure à la tension sur le nœud 16, par exemple inférieure à 0 V. La valeur du signal MODE passe alors de la valeur basse à la valeur haute.

Ainsi, à l'instant T22, le signal P prend la valeur du signal P1, complémentaire du signal P2, c'est-à-dire une valeur basse. Le transistor 100 est alors bloqué. De plus, le transistor 88 devient passant et le transistor 96 devient bloqué. La tension sur le nœud 92 est alors sensiblement égale à la tension VCH, au seuil du transistor 88 près. La tension sur le nœud 92 augmente jusqu'à atteindre la valeur VREF, à un instant T23.

A l'instant T23, le signal de commande du transistor 98, le signal P2, prend une valeur basse et le signal de commande P, c'est-à-dire le signal P1, prend une valeur haute. Ainsi, la tension sur le nœud 92 (courbe 133) prend sensiblement la valeur du nœud 16 et la tension sur le nœud 84 (courbe 131) augmente, le condensateur 84 étant chargé par la source 80. Le signal d'horloge CLK prend donc, à l'instant T23, une valeur haute, qu'il maintient jusqu'à un instant T24 auquel la tension sur le nœud 84 atteint la valeur VREF.

Le circuit 48 alterne par la suite entre des premières phases correspondant à un état bas du signal CLK durant lesquelles :
le transistor 98 est passant et la tension sur le nœud 84 est sensiblement égale à 0 V et
les transistors 100 et 96 sont bloqués, le transistor 88 est passant et la tension sur le nœud 92 augmente jusqu'à atteindre la valeur VREF, ce qui entraine le passage à une deuxième phase.

Durant la deuxième phase, qui correspond à une valeur haute du signal CLK :
le transistor 98 est bloqué et la tension sur le nœud 84 augmente jusqu'à atteindre la valeur VREF, ce qui entraine le passage à la première phase, et
les transistors 100 et 88 sont passants, le transistor 96 est bloqué et la tension sur le nœud 92 est sensiblement égale à 0 V.

Ainsi, la durée entre le passage du mode asynchrone au mode synchrone, c'est-à-dire le passage du signal MODE de la valeur basse à la valeur haute, et le premier front montant du signal d'horloge est le temps entre les instants T22 et T23. Cette durée est causée principalement par le temps nécessaire à la tension du nœud 92 pour atteindre la tension du nœud 94 lorsque le transistor 88 devient passant. Cette durée est relativement courte, par exemple comprise entre 1 ns et 10 ns.

On aurait pu choisir de ne pas maintenir le signal CLK à une valeur constante durant le mode de fonctionnement asynchrone. Les courbes 119, 125 et 127 correspondent à un tel exemple de circuit de génération de signal d'horloge. Dans cet exemple, le circuit ne comprendrait pas de transistors 88 et 96 et pas de circuit 110. Le nœud 94 serait dans cet exemple connecté au nœud 92 et le transistor 100 serait commandé par le signal P1. La durée entre le passage du mode asynchrone au mode synchrone, c'est-à-dire le passage du signal MODE' de la valeur basse à la valeur haute, et le premier front montant du signal d'horloge CLK' dépend de la valeur du signal CLK' lors du passage du mode asynchrone au mode synchrone et pourrait atteindre la valeur de la période du signal CLK'. Dans l'exemple représenté en la figure 7, cette durée correspond à la durée entre des instants T25 et T26, qui est bien plus importante que la durée entre les instants T22 et T23.

Un avantage du mode de réalisation des figures 5 à 7 est que la tension sur le nœud 94 en mode asynchrone, c'est-à-dire la tension VCH est suffisamment proche de la tension VREF que le temps nécessaire à la tension sur le nœud 92 pour atteindre la valeur VREF est faible et le premier front montant du signal d'horloge est proche de l'instant de passage entre le mode asynchrone et le mode synchrone.

Un autre avantage du mode de réalisation des figures 5 et 7 est qu'il ne nécessite l'ajout que de peu de composants électroniques par rapport à la plupart des circuits de génération de signaux d'horloge.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, dans les modes de réalisation décrits, les circuits sont synchronisés sur les fronts montants des signaux d'horloge. Il est évident que les modes de réalisation décrits sont compatibles avec des circuits synchronisés sur des fronts descendants, les modifications étant à la portée de l'homme du métier à partir de la présente description.

Enfin, la mise en œuvre pratique des modes de réalisation et variantes décrits est à la portée de la personne du métier à partir des indications fonctionnelles données ci-dessus.

## Revendications

1. Dispositif comprenant une alimentation à découpage configurée pour avoir un premier mode de fonctionnement (PWM) synchronisé par un premier signal d'horloge (CLK) généré par un premier circuit de génération de signal d'horloge (48) et un deuxième mode de fonctionnement (PSK) asynchrone de suppression d'impulsion, dans lequel le premier circuit de génération (48) est configuré pour que le premier signal (CLK) soit maintenu à une valeur constante durant le deuxième mode de fonctionnement, dans lequel le premier circuit (48) comprend :
une première source de courant (80) reliée en série, entre un nœud (14) d'application d'une première tension d'alimentation (VDD) et un nœud (16) d'application d'une deuxième tension de référence (GND), avec un premier condensateur (82) ;
un premier interrupteur (98) relié en parallèle avec le premier condensateur (82) ;
une deuxième source de courant (86) reliée en série, entre le nœud (14) d'application de la première tension d'alimentation (VDD) et le nœud (16) d'application de la deuxième tension de référence (GND), avec un deuxième interrupteur (88) et un troisième condensateur (90), le deuxième interrupteur (88) et le troisième condensateur (90) étant reliés par un nœud milieu (94), le nœud milieu étant relié par un quatrième interrupteur (96) à un nœud d'application d'une cinquième tension (VCH), la cinquième tension (VCH) étant supérieure ou égale à une quatrième tension de consigne (VREF);
un troisième interrupteur (100) en parallèle avec un ensemble comprenant le troisième condensateur (90) et le deuxième interrupteur (88) ;
un circuit comparateur (102) configuré pour fournir sur une première sortie un deuxième signal (S) représentant la comparaison entre la tension sur le nœud reliant la première source de courant (80) et le premier condensateur (82) et une tension de référence (VREF) égale à la quatrième tension de consigne (VREF) et pour fournir sur une deuxième sortie un troisième signal (R) représentant la comparaison entre la tension sur le nœud reliant la deuxième source de courant (86) et le deuxième interrupteur (88) et la tension de référence (VREF) égale à la quatrième tension de consigne (VREF) ;
une bascule RS (108) comprenant une première entrée reliée à la première sortie du circuit comparateur (102), une deuxième entrée reliée à la deuxième sortie du circuit comparateur (102), une première sortie fournissant un quatrième signal (P2) et une quatrième sortie fournissant un cinquième signal (P1) complémentaire du quatrième signal (P2), le cinquième signal (P1) étant configuré pour être identique au premier signal (CLK) ; et
un circuit de sélection (110) configuré pour recevoir en entrée les quatrième et cinquième signaux et pour fournir en sortie un sixième signal (P),
le premier interrupteur (98) étant configuré pour être commandé par le quatrième signal (P2), le deuxième interrupteur (88) étant configuré pour être commandé par un septième signal (MODE) ayant une première valeur durant le premier mode de fonctionnement et une deuxième valeur durant le deuxième mode de fonctionnement, le quatrième interrupteur (96) étant configuré pour être commandé par un signal complémentaire du septième signal (MODE), le troisième interrupteur (100) étant configuré pour être commandé par le sixième signal (P) et le circuit de sélection étant configuré pour être commandé par le septième signal.

2. Dispositif selon la revendication 1, le dispositif comprenant des premier (20) et deuxième (24) transistors reliés en série entre un nœud (14) d'application d'une première tension d'alimentation (VDD) et un nœud (16) d'application d'une deuxième tension de référence (GND), les premier et deuxième transistors étant reliés l'un à l'autre par un nœud interne (22), les premier et deuxième transistors étant commandés par un deuxième circuit (28) de génération des signaux de commande des premier et deuxième transistors.

3. Dispositif selon la revendication 2, le dispositif comprenant un second condensateur (30) relié entre un nœud de sortie (12) de l'alimentation à découpage et le nœud (16) d'application de la deuxième tension de référence et comprenant une inductance (26) reliée entre le nœud interne (22) et le nœud de sortie (12).

4. Dispositif selon l'une quelconque des revendications 2 et 3, dans lequel, dans le premier mode de fonctionnement, les premier (20) et deuxième (24) transistors sont configurés pour alterner entre des états passant et bloqué périodiquement.

5. Dispositif selon l'une quelconque des revendications 2 à 4, dans lequel, dans le deuxième mode de fonctionnement, le deuxième transistor (24) est configuré pour être maintenu bloqué et le premier transistor (20) est configuré pour être ouvert lorsqu'une troisième tension (VOUT) sur le nœud de sortie (12) est inférieure à une quatrième tension de consigne (VREF).

6. Dispositif selon l'une quelconque des revendications 1 à 5, dans lequel les premier (98) et troisième (100) interrupteurs sont configurés pour être dans un état passant durant le deuxième mode de fonctionnement et pour être dans des états opposés durant le premier mode de fonctionnement.

7. Dispositif selon l'une quelconque des revendications 1 à 6, dans lequel les premier (98) et troisième (100) interrupteurs sont configurés pour recevoir des signaux de commande égaux durant le deuxième mode de fonctionnement et pour recevoir des signaux de commande complémentaires durant le premier mode de fonctionnement.

8. Procédé de commande d'un dispositif comprenant une alimentation à découpage configurée pour avoir un premier mode de fonctionnement (PWM) synchronisé par un premier signal d'horloge (CLK) généré par un premier circuit de génération de signal d'horloge (48) et un deuxième mode de fonctionnement (PSK) asynchrone de suppression d'impulsion, dans lequel le premier circuit de génération (48) maintient le premier signal (CLK) à une valeur constante durant le deuxième mode de fonctionnement, dans lequel le premier circuit (48) comprend :
une première source de courant (80) reliée en série, entre un nœud (14) d'application d'une première tension d'alimentation (VDD) et un nœud (16) d'application d'une deuxième tension de référence (GND), avec un premier condensateur (82) ;
un premier interrupteur (98) relié en parallèle avec le premier condensateur (82) ;
une deuxième source de courant (86) reliée en série, entre le nœud (14) d'application de la première tension d'alimentation (VDD) et le nœud (16) d'application de la deuxième tension de référence (GND), avec un deuxième interrupteur (88) et un troisième condensateur (90), le deuxième interrupteur (88) et le troisième condensateur (90) étant reliés par un nœud milieu (94), le nœud milieu étant relié par un quatrième interrupteur (96) à un nœud d'application d'une cinquième tension (VCH), la cinquième tension (VCH) étant supérieure ou égale à une quatrième tension de consigne (VREF) ; et
un troisième interrupteur (100) en parallèle avec un ensemble comprenant le troisième condensateur (90) et le deuxième interrupteur (88) ;
un circuit comparateur (102), le circuit comparateur (102) fournissant sur une première sortie un deuxième signal (S) représentant la comparaison entre la tension sur le nœud reliant la première source de courant (80) et le premier condensateur (82) et une tension de référence (VREF) égale à la quatrième tension de consigne (VREF) et fournissant sur une deuxième sortie un troisième signal (R) représentant la comparaison entre la tension sur le nœud reliant la deuxième source de courant (86) et le deuxième interrupteur (88) et la tension de référence (VREF) ;
une bascule RS (108) comprenant une première entrée reliée à la première sortie du circuit comparateur (102), une deuxième entrée reliée à la deuxième sortie du circuit comparateur (102), une première sortie fournissant un quatrième signal (P2) et une quatrième sortie fournissant un cinquième signal (P1) complémentaire du quatrième signal (P2), le cinquième signal (P1) étant identique au premier signal (CLK) ; et
un circuit de sélection (110) recevant en entrée les quatrième et cinquième signaux et fournissant en sortie un sixième signal (P),
le premier interrupteur (98) étant commandé par le troisième signal, le deuxième interrupteur étant commandé par un septième signal (MODE) ayant une première valeur durant le premier mode de fonctionnement et une deuxième valeur durant le deuxième mode de fonctionnement, le quatrième interrupteur (96) étant commandé par un signal complémentaire du septième signal (MODE), le troisième interrupteur étant commandé par le sixième signal (P) et le circuit de sélection étant commandé par le septième signal.

## Patentansprüche

1. Vorrichtung, die ein Schaltnetzteil aufweist, das konfiguriert ist, einen ersten Betriebsmodus (PWM) zu haben, der durch ein erstes Taktsignal (CLK) synchronisiert ist, das durch eine erste Taktsignal-Erzeugungsschaltung (48) erzeugt wird, und einen zweiten asynchronen Betriebsmodus (PSK) zum Löschen von Impulsen, wobei die erste Erzeugungsschaltung (48) konfiguriert ist, so dass das erste Signal (CLK) auf einem konstanten Wert gehalten wird, während des zweiten Betriebsmodus, wobei die erste Schaltung (48) Folgendes aufweist:
eine erste Stromquelle (80), die in Reihe geschaltet ist zwischen einem Knoten (14) zum Anlegen einer ersten Versorgungsspannung (VDD) und einem Knoten (16) zum Anlegen einer zweiten Referenzspannung (GND), mit einem ersten Kondensator (82);
einen ersten Schalter (98), der parallel zu dem ersten Kondensator (82) geschaltet ist;
eine zweite Stromquelle (86), die in Reihe geschaltet ist zwischen dem Knoten (14) zum Anlegen der ersten Versorgungsspannung (VDD) und dem Knoten (16) zum Anlegen der zweiten Referenzspannung (GND), mit einem zweiten Schalter (88) und einem dritten Kondensator (90), wobei der zweite Schalter (88) und der dritte Kondensator (90) durch einen mittleren Knoten (94) gekoppelt sind, wobei der mittlere Knoten durch einen vierten Schalter (96) mit einem Knoten zum Anlegen einer fünften Spannung (VCH) gekoppelt ist, wobei die fünfte Spannung (VCH) größer oder gleich einer vierten Sollwertspannung (VREF) ist;
einen dritten Schalter (100) parallel zu einer Anordnung, die den dritten Kondensator (90) und den zweiten Schalter (88) aufweist;
eine Komparatorschaltung (102), die konfiguriert ist zum Bereitstellen an einem ersten Ausgang eines zweiten Signals (S), das repräsentativ für den Vergleich zwischen der Spannung an dem Knoten ist, der die erste Stromquelle (80) und den ersten Kondensator (82) koppelt, und einer Referenzspannung (VREF), die gleich der vierten Sollwertspannung (VREF) ist, und zum Bereitstellen eines dritten Signals (R) an einem zweiten Ausgang, das repräsentativ für den Vergleich zwischen der Spannung an dem Knoten ist, der die zweite Stromquelle (86) und den zweiten Schalter (88) koppelt, und der Referenzspannung (VREF);
ein RS-Flipflop (108), das einen ersten Eingang aufweist, der mit dem ersten Ausgang der Komparatorschaltung (102) gekoppelt ist, einem zweiten Eingang, der mit dem zweiten Ausgang der Komparatorschaltung (102) gekoppelt ist, einem ersten Ausgang, der ein viertes Signal (P2) bereitstellt, und einem vierten Ausgang, der ein fünftes Signal (P1) bereitstellt, das zum vierten Signal (P2) komplementär ist, wobei das fünfte Signal (P1) konfiguriert ist, um dasselbe wie das erste Signal (CLK) zu sein; und
eine Auswahlschaltung (110), die konfiguriert ist zum Empfangen des vierten und fünften Signals als Eingang und zum Bereitstellen eines sechsten Signals (P) als Ausgang,
wobei der erste Schalter (98) konfiguriert ist, um durch das vierte Signal (P2) gesteuert zu werden, der zweite Schalter (88) konfiguriert ist, um durch ein siebtes Signal (MODE) gesteuert zu werden, das während des ersten Betriebsmodus einen ersten Wert hat und während des zweiten Betriebsmodus einen zweiten Wert hat, der vierte Schalter (96) konfiguriert ist, um durch ein Signal gesteuert zu werden, das zum siebten Signal (MODE) komplementär ist, wobei der dritte Schalter (100) konfiguriert ist, um durch das sechste Signal (P) gesteuert zu werden, und wobei die Auswahlschaltung konfiguriert ist, um durch das siebte Signal gesteuert zu werden.

2. Vorrichtung nach Anspruch 1, wobei die Vorrichtung erste (20) und zweite (24) Transistoren aufweist, die in Reihe geschaltet sind zwischen einem Knoten (14) zum Anlegen einer ersten Versorgungsspannung (VDD) und einem Knoten (16) zum Anlegen einer zweiten Referenzspannung (GND), wobei der erste und der zweite Transistor durch einen internen Knoten (22) miteinander gekoppelt sind, wobei der erste und der zweite Transistor durch eine zweite Schaltung (28) zum Erzeugen der Steuersignale des ersten und des zweiten Transistors gesteuert werden.

3. Vorrichtung nach Anspruch 2, wobei die Vorrichtung einen zweiten Kondensator (30) aufweist, der zwischen einem Ausgangsknoten (12) des Schaltnetzteils und dem Knoten (16) zum Anlegen der zweiten Referenzspannung gekoppelt ist, und eine Induktivität (26) aufweist, die zwischen dem internen Knoten (22) und dem Ausgangsknoten (12) gekoppelt ist.

4. Vorrichtung nach einem der Ansprüche 2 und 3, wobei im ersten Betriebsmodus der erste (20) und der zweite (24) Transistor konfiguriert sind, um periodisch zwischen EIN- und AUS-Zuständen zu wechseln.

5. Vorrichtung nach einem der Ansprüche 2 bis 4, wobei, im zweiten Betriebsmodus, der zweite Transistor (24) konfiguriert ist, ausgeschaltet zu bleiben, und der erste Transistor (20) konfiguriert ist, offen zu sein, wenn eine dritte Spannung (VOUT) am Ausgangsknoten (12) niedriger ist als eine vierte Sollwertspannung (VREF).

6. Vorrichtung nach einem der Ansprüche 1 bis 5, wobei der erste (98) und der dritte (100) Schalter konfiguriert sind, um sich während des zweiten Betriebsmodus in einem EIN-Zustand zu befinden und sich während des ersten Betriebsmodus in entgegengesetzten Zuständen zu befinden.

7. Vorrichtung nach einem der Ansprüche 1 bis 6, wobei der erste (98) und der dritte (100) Schalter konfiguriert sind zum Empfangen gleicher Steuersignale während des zweiten Betriebsmodus und zum Empfangen komplementärer Steuersignale während des ersten Betriebsmodus.

8. Verfahren zum Steuern einer Vorrichtung, die ein Schaltnetzteil aufweist, das konfiguriert ist, einen ersten Betriebsmodus (PWM) zu haben, der durch ein erstes Taktsignal (CLK) synchronisiert ist, das durch eine erste Taktsignal-Erzeugungsschaltung (48) erzeugt wird, und einen zweiten asynchronen Betriebsmodus (PSK) zum Löschen von Impulsen, wobei die erste Erzeugungsschaltung (48) das erste Signal (CLK) auf einem konstanten Wert hält, wobei die erste Schaltung (48) Folgendes aufweist:
eine erste Stromquelle (80), die in Reihe geschaltet ist zwischen einem Knoten (14) zum Anlegen einer ersten Versorgungsspannung (VDD) und einem Knoten (16) zum Anlegen einer zweiten Referenzspannung (GND), mit einem ersten Kondensator (82);
einen ersten Schalter (98), der parallel zu dem ersten Kondensator (82) geschaltet ist;
eine zweite Stromquelle (86), die in Reihe geschaltet ist zwischen dem Knoten (14) zum Anlegen der ersten Versorgungsspannung (VDD) und dem Knoten (16) zum Anlegen der zweiten Referenzspannung (GND), mit einem zweiten Schalter (88) und einem dritten Kondensator (90), wobei der zweite Schalter (88) und der dritte Kondensator (90) durch einen mittleren Knoten (94) gekoppelt sind, wobei der mittlere Knoten durch einen vierten Schalter (96) mit einem Knoten zum Anlegen einer fünften Spannung (VCH) gekoppelt ist, wobei die fünfte Spannung (VCH) größer oder gleich einer vierten Sollwertspannung (VREF) ist; und
einen dritten Schalter (100) parallel zu einer Anordnung, die den dritten Kondensator (90) und den zweiten Schalter (88) aufweist;
Bereitstellen eines zweiten Signals (S) durch eine Komparatorschaltung (102) mit einem ersten Ausgang, das repräsentativ für den Vergleich zwischen der Spannung an dem Knoten ist, der die erste Stromquelle (80) und den ersten Kondensator (82) koppelt, und einer Referenzspannung (VREF), die gleich der vierten Sollwertspannung (VREF) ist, und Bereitstellen eines dritten Signals (R) an einem zweiten Ausgang, das repräsentativ für den Vergleich zwischen der Spannung an dem Knoten ist, der die zweite Stromquelle (86) und den zweiten Schalter (88) koppelt, und der Referenzspannung (VREF);
ein RS-Flipflop (108), das einen ersten Eingang aufweist, der mit dem ersten Ausgang der Komparatorschaltung (102) gekoppelt ist, einem zweiten Eingang, der mit dem zweiten Ausgang der Komparatorschaltung (102) gekoppelt ist, einem ersten Ausgang, der ein viertes Signal (P2) bereitstellt, und einem vierten Ausgang, der ein fünftes Signal (P1) bereitstellt, das zum vierten Signal (P2) komplementär ist, wobei das fünfte Signal (P1) dasselbe wie das erste Signal (CLK) ist; und
eine Auswahlschaltung (110), die das vierte und fünfte Signal als Eingang empfängt und ein sechstes Signals (P) als Ausgang bereitstellt,
wobei der erste Schalter (98) durch das dritte Signal gesteuert wird, der zweite Schalter durch ein siebtes Signal (MODE) gesteuert wird, das während des ersten Betriebsmodus einen ersten Wert und während des zweiten Betriebsmodus einen zweiten Wert hat, der vierte Schalter (96) durch ein Signal gesteuert wird, das zum siebten Signal (MODE) komplementär ist, der dritte Schalter durch das sechste Signal (P) gesteuert wird und die Auswahlschaltung durch das siebte Signal gesteuert wird.

## Claims

1. Device comprising a switching power supply configured to have a first operating mode (PWM) synchronized by a first clock signal (CLK) generated by a first clock signal generating circuit (48) and a second asynchronous operating mode (PSK) for deleting pulse, wherein the first generating circuit (48) is configured so that the first signal (CLK) is maintained at a constant value during the second operating mode, wherein the first circuit (48) comprises:
a first current source (80) coupled in series, between a node (14) for applying a first supply voltage (VDD) and a node (16) for applying a second reference voltage (GND), with a first capacitor (82);
a first switch (98) coupled in parallel with the first capacitor (82);
a second current source (86) coupled in series, between the node (14) for applying the first supply voltage (VDD) and the node (16) for applying the second reference voltage (GND), with a second switch (88) and a third capacitor (90), the second switch (88) and the third capacitor (90) being coupled by a middle node (94), the middle node being coupled by a fourth switch (96) to a node for applying a fifth voltage (VCH), the fifth voltage (VCH) being greater than or equal to a fourth setpoint voltage (VREF);
a third switch (100) in parallel with an assembly comprising the third capacitor (90) and the second switch (88);
a comparator circuit (102) configured for providing at a first output a second signal (S) representative of the comparison between the voltage at node coupling the first current source (80) and the first capacitor (82) and a reference voltage (VREF) equal to the fourth setpoint voltage (VREF), and for providing at a second output a third signal (R) representative of the comparison between the voltage at node coupling the second current source (86) and the second switch (88) and the reference voltage (VREF);
a RS flip-flop (108) comprising a first input coupled to the first output of the comparator circuit (102), a second input coupled to the second output of the comparator circuit (102), a first output providing a fourth signal (P2), and a fourth output providing a fifth signal (P1) complementary to the fourth signal (P2), the fifth signal (P1) being configured to be same as the first signal (CLK); et
a selection circuit (110) configured to receive as input the fourth and fifth signals, and to provide as output a sixth signal (P),
the first switch (98) being configured to be controlled by the fourth signal (P2), the second switch (88) being configured to be controlled by a seventh signal (MODE) having a first value during the first operating mode and a second value during the second operating mode, the fourth switch (96) being configured to be controlled by a signal complementary to the seventh signal (MODE), the third switch (100) being configured to be controlled by the sixth signal (P), and the selection circuit being configured to be controlled by the seventh signal.

2. Device according to claim 1, the device comprising first (20) and second (24) transistors coupled in series between a node (14) for applying a first supply voltage (VDD) and a node (16) for applying a second reference voltage (GND), the first and second transistors being coupled to each other by an internal node (22), the first and second transistors being controlled by a second circuit (28) for generating the control signals of the first and second transistors.

3. Device according to claim 2, the device comprising a second capacitor (30) coupled between an output node (12) of the switching power supply and the node (16) for applying the second reference voltage and comprising an inductor (26) coupled between the internal node (22) and the output node (12).

4. Device according to any one of claims 2 and 3, wherein in the first operating mode, the first (20) and second (24) transistors are configured to periodically alternate between ON and OFF states.

5. Device according to any one of claims 2 to 4, wherein, in the second operating mode, the second transistor (24) is configured to be kept OFF, and the first transistor (20) is configured to be open when a third voltage (VOUT) at the output node (12) is lower than a fourth setpoint voltage (VREF).

6. Device according to any one of claims 1 to 5, wherein the first (98) and third (100) switches are configured to be in an ON state during the second operating mode and to be in opposite states during the first operating mode.

7. Device according to any one of claims 1 to 6, wherein the first (98) and third (100) switches are configured to receive equal control signals during the second operating mode and to receive complementary control signals during the first operating mode.

8. Method for controlling a device comprising a switching power supply configured to have a first operating mode (PWM) synchronized by a first clock signal (CLK) generated by a first clock signal generating circuit (48) and a second asynchronous operating mode (PSK) for deleting pulse, wherein the first generating circuit (48) maintains the first signal (CLK) at a constant value during the second operating mode, wherein the first circuit (48) comprises:
a first current source (80) coupled in series, between a node (14) for applying a first supply voltage (VDD) and a node (16) for applying a second reference voltage (GND), with a first capacitor (82);
a first switch (98) coupled in parallel with the first capacitor (82);
a second current source (86) coupled in series, between the node (14) for applying the first supply voltage (VDD) and the node (16) for applying the second reference voltage (GND), with a second switch (88) and a third capacitor (90), the second switch (88) and the third capacitor (90) being coupled by a middle node (94), the middle node being coupled by a fourth switch (96) to a node for applying a fifth voltage (VCH), the fifth voltage (VCH) being greater than or equal to a fourth setpoint voltage (VREF); and
a third switch (100) in parallel with an assembly comprising the third capacitor (90) and the second switch (88);
providing, by a comparator circuit (102) having a first output, a second signal (S) representative of the comparison between the voltage at node coupling the first current source (80) and the first capacitor (82) and a reference voltage (VREF) equal to the fourth setpoint voltage (VREF), and providing at a second output a third signal (R) representative of the comparison between the voltage at node coupling the second current source (86) and the second switch (88) and the reference voltage (VREF);
a RS flip-flop (108) comprising a first input coupled to the first output of the comparator circuit (102), a second input coupled to the second output of the comparator circuit (102), a first output providing a fourth signal (P2), and a fourth output providing a fifth signal (P1) complementary to the fourth signal (P2), the fifth signal (P1) being same as the first signal (CLK); and
a selection circuit (110) receiving as input the fourth and fifth signals, and providing as output a sixth signal (P),
the first switch (98) being controlled by the third signal, the second switch being controlled by a seventh signal (MODE) having a first value during the first operating mode and a second value during the second operating mode, the fourth switch (96) being controlled by a signal complementary to the seventh signal (MODE), the third switch being controlled by the sixth signal (P) and the selection circuit being controlled by the seventh signal.
